# EUROPEAN PATENT SPECIFICATION

(11) **EP 2 903 160 B1**
(45) Date of publication and mention of the grant of the patent: **09.09.2020**
(21) Application number: 15152367.7
(22) Date of filing: 23.01.2015
(51) Int. Cl.: H03K 17/687, H03K 17/06, H02M 1/32

(54) **Power supply device and control method of power supply device**
Stromversorgungsvorrichtung und Steuerungsverfahren der Stromversorgungsvorrichtung
Dispositif d'alimentation électrique et procédé de commande d'un tel dispositif

(30) Priority: 03.02.2014 JP 2014018371
(43) Date of publication of application: 05.08.2015
(73) Proprietor: Mitsubishi Electric Corporation, Chiyoda-ku Tokyo 100-8310 (JP)
(72) Inventor: Kutsuki, Tomohiro, Tokio, 100-8310 (JP); Umehara, Shigeo, Tokio, 100-8310 (JP)
(74) Representative: Pfenning, Meinig & Partner mbB

(56) References cited:
- WO-A1-2013/157303
- US-B1- 7 312 593

## Description

### 1. Field of the Invention

The present invention relates to a power supply device that has a semiconductor device using a wide bandgap semiconductor, and performs a converter operation for converting AC power to DC power or an inverter operation for converting DC power to AC power.

### 2. Description of the Related Art

As conventional power supply devices, there is a power supply device that uses a booster circuit having a reactor, a diode, and a semiconductor switching device to perform a converter operation, in order to improve the power factor of an input current and raise an output voltage (for example, a converter device using a boost chopper circuit). Furthermore, there is a power supply device that includes a power-factor improving circuit using an interleaving method, as a developed form of the power supply device. In the power supply device using the interleaving method, a high voltage side of an input terminal is branched to two or more current paths, a circuit including a reactor, a semiconductor switching device, and a diode is connected to each of the branched paths, so that these semiconductor switching devices respectively perform a switching operation alternately, thereby suppressing a harmonic noise current (for example, see Japanese Patent Application Laid-open No. H11-289766 and Japanese Patent Application Laid-open No. 2007-195282).

According to the power supply device using the interleaving method, ripple components of the current can be reduced as a switching frequency of the semiconductor switching device is increased, thereby enabling downsizing of the reactor. However, an increase of the switching frequency causes an increase of power loss in the semiconductor switching device. Therefore, it can be considered to use a semiconductor switching device formed of a wide bandgap semiconductor such as silicon carbide (SiC) as the semiconductor switching device (for example, a MOSFET), instead of using an insulated gate bipolar transistor (IGBT) and a metal-oxide-semiconductor field-effect transistor (MOSFET) formed of a silicon (Si) semiconductor, to enable high-frequency drive of the semiconductor switching device, while suppressing power loss in the semiconductor switching device.

It is known that because the MOSFET formed of the SiC semiconductor (hereinafter, "SiC-MOSFET") has a device characteristic such that channel mobility thereof is lower than channel mobility of the Si-MOSFET, the electric resistance of a channel portion of the SiC-MOSFET becomes higher than the electric resistance of a channel portion of the Si-MOSFET. Therefore, when the SiC-MOSFET is used as the semiconductor switching device of the power supply device described above, it is considered to reduce the electric resistance of the channel portion of the MOSFET by setting a gate voltage of the semiconductor switching device to be higher than a gate voltage of the Si-MOSFET.

However, generally, in the MOSFET, the electric withstanding voltage performance of a gate is low. Therefore, in many cases, it is difficult to increase the gate voltage. In order to increase the gate voltage of the SiC-MOSFET, it is required to add a DC voltage source having a higher voltage (for example, 18 volts) for the gate voltage of the SiC-MOSFET, or add a circuit for increasing a DC voltage, separately from a DC voltage source (for example, 15 volts) for circuit elements other than the SiC-MOSFET. Therefore, when there is a restriction on a substrate area of an electronic substrate, addition of a new power supply or the like is not possible, and thus a higher voltage may not be realized for the gate voltage.

When the SiC-MOSFET is used in a state where a gate voltage is not high as explained above (for example, the gate voltage falls below 15 volts) and in an operating temperature environment at an extremely low temperature (for example, -50°C), the channel mobility of the SiC-MOSFET becomes abnormally low. Accordingly, the conduction resistance considerably increases and the MOSFET device may be broken due to rapid heat generation. Therefore, it has been difficult to realize a power supply device that operates in such an extremely low temperature environment.

The present invention has been achieved in view of solving the above problems, and an object of the present invention is to provide a power supply device that uses a SiC-MOSFET for a semiconductor switching device and can operate in a low temperature environment.

US7312593 B1 discloses an apparatus for the thermal regulation of an AC drive for providing power to a motor, wherein the apparatus includes a temperature sensor producing a signal indicative of temperature, a heater resistor connectable across a DC link of the AC drive, and a first switch. A controller is operable to monitor the temperature signal and control the first switch to provide power via the DC link to the heater resistor if the sensed temperature is below a predetermined setpoint.

### SUMMARY OF THE INVENTION

It is an object of the present invention to at least partially solve the problems in the conventional technology.

A power supply device according to the present invention is provided according to independent claim 1. The power supply device includes: a power conversion unit that includes one or more first semiconductor switching devices and performs a converter operation configured to convert an AC power to a DC power or an inverter operation configured to convert a DC power to an AC power; a heating resistor configured to heat the first semiconductor switching devices; a second semiconductor switching device configured to control conduction of the heating resistor; a temperature detection unit configured to detect a temperature of a heatsink provided for heat dissipation of the first semiconductor switching devices or an outside air temperature; and a control unit configured to generate a drive signal for controlling ON and OFF of the first semiconductor switching devices and the second semiconductor switching device by using a temperature detected by the temperature detection unit.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a configuration diagram of a power supply device according to a first example;
FIG. 2 is an operation flowchart for explaining control operations according to the first example;
FIG. 3 is a configuration diagram of a power supply device according to a first embodiment of the present invention;
FIG. 4 is an operation flowchart for explaining control operations according to the first embodiment;
FIG. 5 shows a configuration of energizing-time threshold data according to the first embodiment;
FIG. 6 is a configuration diagram (a modification) of the power supply device according to the first example;
FIG. 7 is a configuration diagram (another modification) of the power supply device according to the first example;
FIG. 8 is a configuration diagram of a power supply device according to a second embodiment of the present invention; and
FIG. 9 is an operation flowchart for explaining control operations according to the second embodiment.

### DETAILED DESCRIPTION OF THE PREFERRED EMBODIMENTS

### First Example.

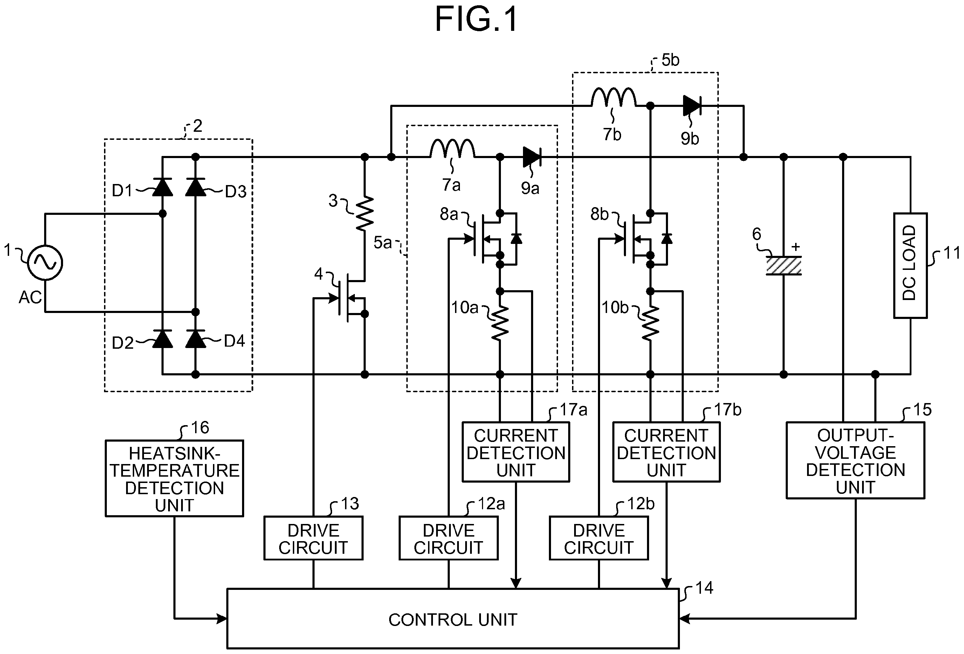

Configurations and operations of a power supply device according to a first example are explained with reference to the accompanying drawings. The first example does not form part of the invention, but is used for a better understanding of the application. FIG. 1 is a configuration diagram of the power supply device (a converter device) that performs a converter operation for converting AC power to DC power. In the power supply device shown in FIG. 1, an AC power supply 1 being a single-phase AC power supply is connected to a rectifying unit 2 being a bridge circuit (a full-wave rectifying circuit) including diodes D1 to D4, and a heating resistor 3 and a semiconductor switching device 4 (for example, a silicon n-type MOSFET) formed of a silicon semiconductor are serially connected between a positive-side output terminal and a negative-side output terminal of the rectifying unit 2. Boosters 5a and 5b are connected in parallel to a high-potential output terminal of the rectifying unit 2, and output terminals of the boosters 5a and 5b are connected to a smoothing unit (an output capacitor) 6. A DC load 11 such as an inverter is connected in parallel between terminals of the smoothing unit 6. The DC load 11 operates as power is supplied from the smoothing unit 6.

The booster 5a includes a reactor 7a that functions as a boosting reactor, a semiconductor switching device 8a, a backflow prevention diode 9a, and a shunt resistor 10a. The booster 5b also has the same configuration as the booster 5a, and includes a reactor 7a that functions as a boosting reactor, a semiconductor switching device 8b, a backflow prevention diode 9b, and a shunt resistor 10b. The rectifying unit 2, the boosters 5a and 5b, and the smoothing unit 6 constitute a power conversion unit that performs a converter operation.

The semiconductor switching device 8a is constituted by a semiconductor switching device (for example, a SiC n-type MOSFET) formed of a wide bandgap semiconductor such as silicon carbide (SiC), a gallium nitride (GaN)-based material, or diamond. A collector or a drain of the semiconductor switching device 8a is connected between the reactor 7a and the backflow prevention diode 9a, and an emitter or a source thereof is connected to the negative-side output terminal of the rectifying unit 2 and a negative-side terminal of the smoothing unit 6 via the shunt resistor 10a. Similarly, the semiconductor switching device 8b is constituted by a semiconductor switching device formed of a wide bandgap semiconductor such as SiC. A collector or a drain of the semiconductor switching device 8b is connected between the reactor 7b and the backflow prevention diode 9b, and an emitter or a source thereof is connected to the negative-side output terminal of the rectifying unit 2 and the negative-side terminal of the smoothing unit 6 via the shunt resistor 10b.

In the backflow prevention diode 9a, an anode thereof is connected to the reactor 7a and the semiconductor switching device 8a, and a cathode thereof is connected to the smoothing unit 6. In the backflow prevention diode 9b, an anode thereof is connected to the reactor 7b and the semiconductor switching device 8b, and a cathode thereof is connected to the smoothing unit 6.

An output-voltage detection unit 15 is connected to the both terminals of the smoothing unit 6 to detect a DC voltage between the terminals of the smoothing unit 6. A heatsink-temperature detection unit 16 is constituted by a thermistor or the like, and is installed around a heatsink (not shown) provided for heat dissipation of respective devices of the semiconductor switching devices 8a and 8b or installed in direct contact with the heatsink to detect the temperature of the heatsink. Furthermore, current detection units 17a and 17b respectively detect an electric current that flows in the shunt resistors 10a and 10b based on the voltage between the both ends of the shunt resistors 10a and 10b.

A control unit 14 generates a drive signal for ON/OFF control of the semiconductor switching device 4 and the semiconductor switching devices 8a and 8b based on: a voltage between the both terminals of the smoothing unit 6 detected by the output-voltage detection unit 15; a value of an electric current that flows in the shunt resistors 10a and 10b detected by the current detection units 17a and 17b; and a heatsink temperature detected by the heatsink-temperature detection unit 16, and the semiconductor switching device 4 outputs the drive signal to drive circuits 12a and 12b, and to a drive circuit 13. Specifically, the control unit 14 is realized by a microcomputer or a microprocessor such as a digital signal processor (DSP). However, the control unit 14 may be constituted by combining computing circuits other than a microcomputer and a microprocessor.

The drive circuits 12a and 12b are respectively connected to gate terminals of the semiconductor switching devices 8a and 8b, and the drive circuit 13 is connected to a gate terminal of the semiconductor switching device 4. The drive circuits 12a and 12b, and the drive circuit 13 respectively generate a gate control signal for driving the gate terminals of the semiconductor switching device 4 and the semiconductor switching devices 8a and 8b based on the drive signal output from the control unit 14, and respectively execute drive control of the semiconductor switching device 4 and the semiconductor switching devices 8a and 8b.

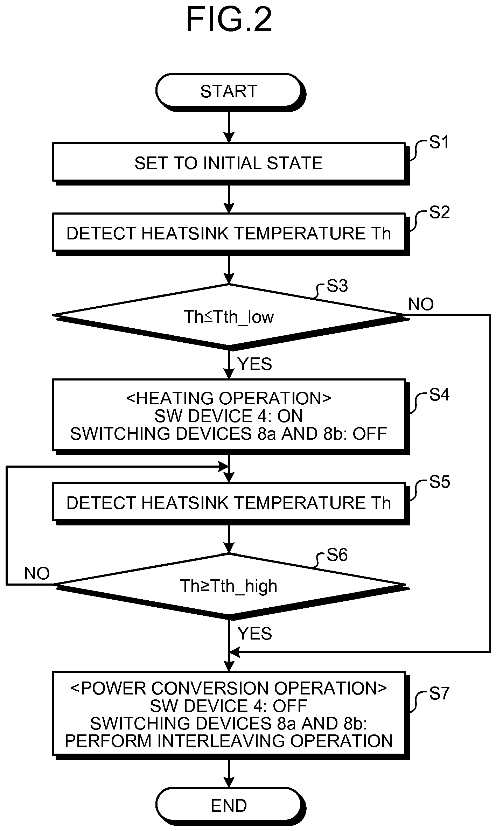

Operations of the power supply device configured in the above described manner will be explained next. The control unit 14 controls a switching operation of the semiconductor switching device 4 and the semiconductor switching devices 8a and 8b according to an operation flow shown in FIG. 2. Operations will be explained according to an operation flowchart.

The control unit 14 first outputs a drive signal to set the semiconductor switching device 4 and the semiconductor switching devices 8a and 8b to an OFF state, respectively, to the drive circuit 13 and the drive circuits 12a and 12b, thereby setting the power supply device to an initial state before starting a power conversion operation (a converter operation) (Step S1).

At the time of shifting of the power supply device to the power conversion operation, the control unit 14 detects a heatsink temperature Th by the heatsink-temperature detection unit 16 (Step S2), and compares a low temperature threshold Tth_low, which is a threshold temperature set to the power supply device in advance, with the detected heatsink temperature Th (Step S3).

The value of the low temperature threshold Tth_low means a lower limit temperature for permitting conduction of a wide bandgap semiconductor device, which is used in the semiconductor switching devices 8a and 8b, and in the case of a SiC-MOSFET, for example, the low temperature threshold Tth_low may be set to -50°C. The temperature of the heatsink is lower than the temperature of the wide bandgap semiconductor device that constitutes the semiconductor switching devices 8a and 8b. Therefore, in a state where the heatsink temperature Th is higher than the low temperature threshold Tth_low, it can be regarded that the temperature of a device element constituting the semiconductor switching devices 8a and 8b is also higher than the low temperature threshold Tth_low.

When the heatsink temperature Th is higher than the low temperature threshold Tth_low (NO at Step S3), the control unit 14 maintains the OFF state of the semiconductor switching device 4, and starts an interleaving operation of the semiconductor switching devices 8a and 8b. Accordingly, the power conversion operation (a power-factor improving converter operation) of the power supply device is realized (Step S7).

The interleaving operation of the semiconductor switching devices 8a and 8b is explained here. In the interleaving operation, the semiconductor switching device 8a is set to an ON state to accumulate electromagnetic energy in the reactor 7a, and then the semiconductor switching device 8a is set to an OFF state to supply the electromagnetic energy as an output current to the smoothing unit 6 via the backflow prevention diode 9a. The semiconductor switching device 8b also supplies the electromagnetic energy accumulated in the reactor 7b to the smoothing unit 6 via the backflow prevention diode 9b similarly to the semiconductor switching device 8a.

The control unit 14 performs the interleaving operation by adjusting a ratio (an ON/OFF ratio) between a duration time of the ON state and a duration time of the OFF state of the semiconductor switching devices 8a and 8b and a phase of an ON/OFF timing, based on: a current value in the shunt resistor 10a detected by the current detection unit 17a; a current value in the shunt resistor 10b detected by the current detection unit 17b; and a DC voltage value between terminals of the smoothing unit 6 detected by the output-voltage detection unit 15. By causing the semiconductor switching devices 8a and 8b to perform the interleaving operation in the above described manner, a harmonic noise current caused by the switching operation can be suppressed.

When the heatsink temperature Th is equal to or lower than the low temperature threshold Tth_low (YES at Step S3), the control unit 14 sets the semiconductor switching device 4 to an ON state. Accordingly, the heating resistor 3 is energized, and the semiconductor switching devices 8a and 8b are heated (a heating operation) by heat generation due to conduction loss of the heating resistor 3, to increase the temperature of the semiconductor switching devices 8a and 8b. The semiconductor switching devices 8a and 8b maintain the OFF state and do not perform the switching operation (Step S4).

For more effective heating of the semiconductor switching devices 8a and 8b, it is desirable to arrange the heating resistor 3 in the vicinity of the semiconductor switching devices 8a and 8b, or arrange the heating resistor 3 in contact with the semiconductor switching devices 8a and 8b.

The control unit 14 detects the heatsink temperature Th by the heatsink-temperature detection unit 16 (Step S5), and compares the detected heatsink temperature Th with a high temperature threshold Tth_high, which is a threshold temperature set to the power supply device in advance (Step S6) .

The value of the high temperature threshold Tth_high is set to be higher than the temperature of the low temperature threshold Tth_low (Tth_high>Tth_low). In the case of a SiC-MOSFET, for example, it may be set to Tth_high = -20°C. When a temperature difference ΔT between the high temperature threshold Tth_high and the low temperature threshold Tth_low is small, control may become unstable due to a detection error or the like of the heatsink-temperature detection unit 16. Therefore, it is desirable to set the temperature difference ΔT to be large to some extent, in order to ensure stability of the control.

When the heatsink temperature Th is lower than the high temperature threshold Tth_high (NO at Step S6), the flow returns to Step S5 to continue detecting the heatsink temperature, and to continue comparing the detected heatsink temperature Th with the high temperature threshold Tth_high. When the semiconductor switching devices 8a and 8b are heated and the temperature of the semiconductor switching devices 8a and 8b increases, the temperature of the heatsink itself attached to the semiconductor switching devices 8a and 8b also increases. Therefore, by confirming the heatsink temperature Th continuously, a temperature rise of the semiconductor switching devices 8a and 8b can be estimated.

When the heatsink temperature Th is equal to or higher than the high temperature threshold Tth_high (YES at Step S6), the control unit 14 sets the semiconductor switching device 4 to an OFF state to stop energizing of the heating resistor 3. Accordingly, the heating operation to heat the semiconductor switching devices 8a and 8b is stopped. Furthermore, the interleaving operation of the switching of the semiconductor switching devices 8a and 8b is started. Accordingly, the power conversion operation (the power-factor improving converter operation) of the power supply device is realized (Step S7).

When the semiconductor switching devices 8a and 8b can start the switching operation normally, the temperature of the semiconductor switching devices 8a and 8b gradually increases by self-heating caused by the switching operation. Therefore, the temperature of the semiconductor switching devices 8a and 8b does not drop to a low temperature region in which there is a risk of thermal destruction. Thereafter, the semiconductor switching devices 8a and 8b can be operated continuously in an appropriate temperature range by a cooling function of the heatsink and a cooling fan (not shown).

In the above explanations, both of the semiconductor switching devices 8a and 8b are formed of a wide bandgap semiconductor. However, the semiconductor switching devices 8a and 8b are not limited thereto, but only one of the semiconductor switching devices 8a and 8b may be a semiconductor switching device formed of a wide bandgap semiconductor, and the other may be a semiconductor switching device formed of an Si semiconductor.

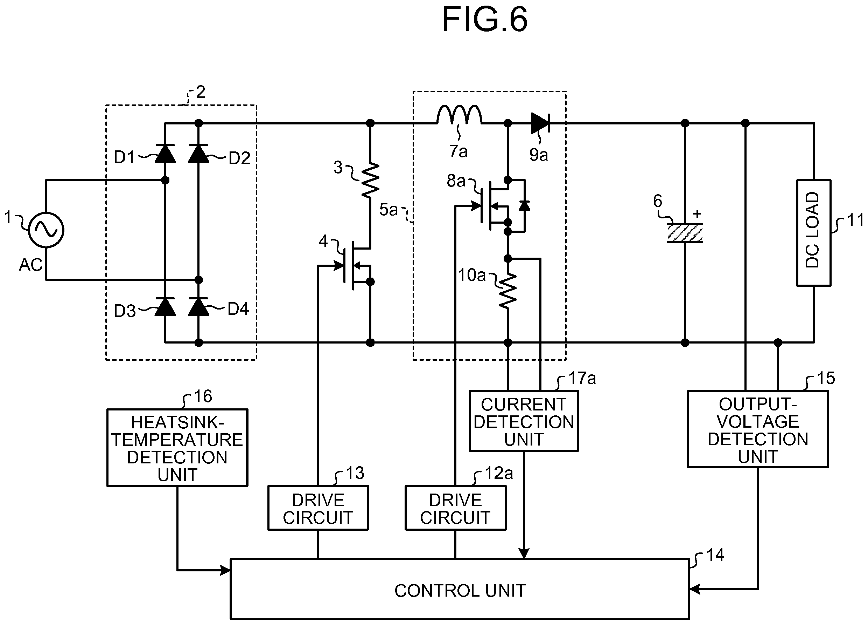

In the above explanations, the power supply device has a two-phase configuration including two boosters (boosters 5a and 5b). However, the power supply device is not limited thereto, and the booster may be one (the booster 5a), or the booster may have a multi-phase configuration by connecting boosters in parallel in several stages, other than the boosters 5a and 5b. As an example, a configuration including only one booster is shown in FIG. 6. In FIG. 6, a booster has a one-phase configuration by deleting the booster 5b, the current detection unit 17b, and the drive circuit 12b from the configuration shown in FIG. 1, and the control unit 14 controls the semiconductor switching device 4 and the semiconductor switching device 8a, respectively, based on a voltage between the both terminals of the smoothing unit 6 detected by the output-voltage detection unit 15 and a heatsink temperature detected by the heatsink-temperature detection unit 16 to perform power conversion (the converter operation). An operation flow of the control unit 14 is basically the same as that shown in FIG. 2, except that the power conversion operation is a boost converter operation that does not use an interleaving operation, and thus explanations thereof will be omitted.

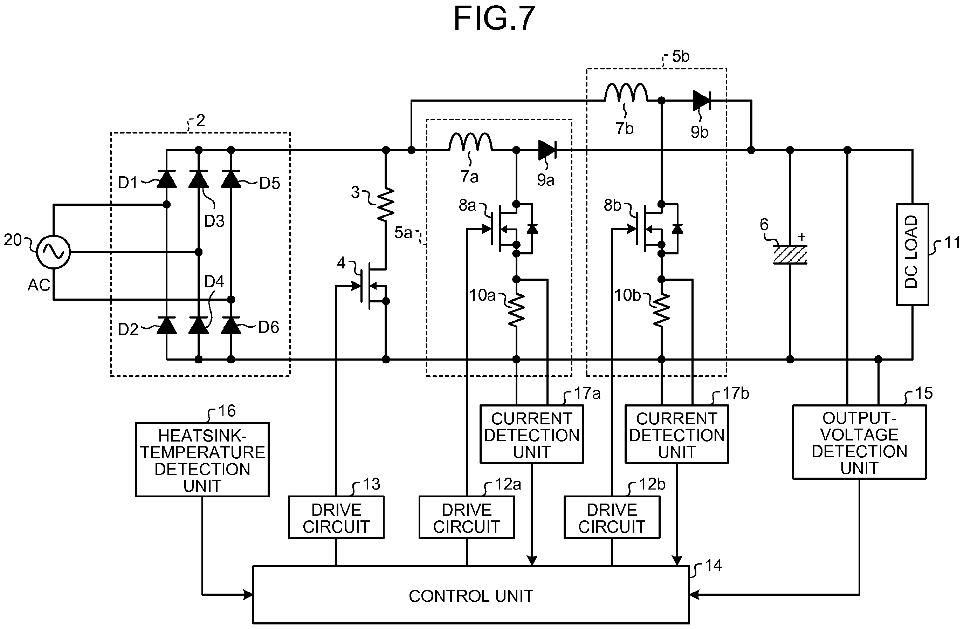

In the above explanations, the AC power supply 1 is a single-phase AC power supply. However, as shown in FIG. 7, a three-phase AC power supply 20 may be used. In this case, the rectifying unit is a rectifying unit 21 being a bridge circuit that includes diodes D1 to D6. Because other circuit configurations and circuit operations are the same as those explained with reference to FIGS. 1 and 2, explanations thereof will be omitted.

In the power supply device according to the first example, when the device temperature of the semiconductor switching device formed of a wide bandgap semiconductor such as silicon carbide (SiC) used by the power supply device is in a low temperature region in which a stable operation cannot be ensured, the semiconductor switching device is heated by heat generated by energizing the heating resistor, so that the temperature of the semiconductor switching device is changed to a temperature region in which a stable operation can be performed. After it is confirmed that the temperature of the semiconductor switching device has changed to the temperature region in which a stable operation can be performed, switching operation control of the semiconductor switching device is executed. Accordingly, even at the time of startup of the power supply device in a low temperature environment, thermal destruction of the semiconductor switching device can be prevented and the temperature region capable of starting energizing the power supply device can be extended.

### First embodiment.

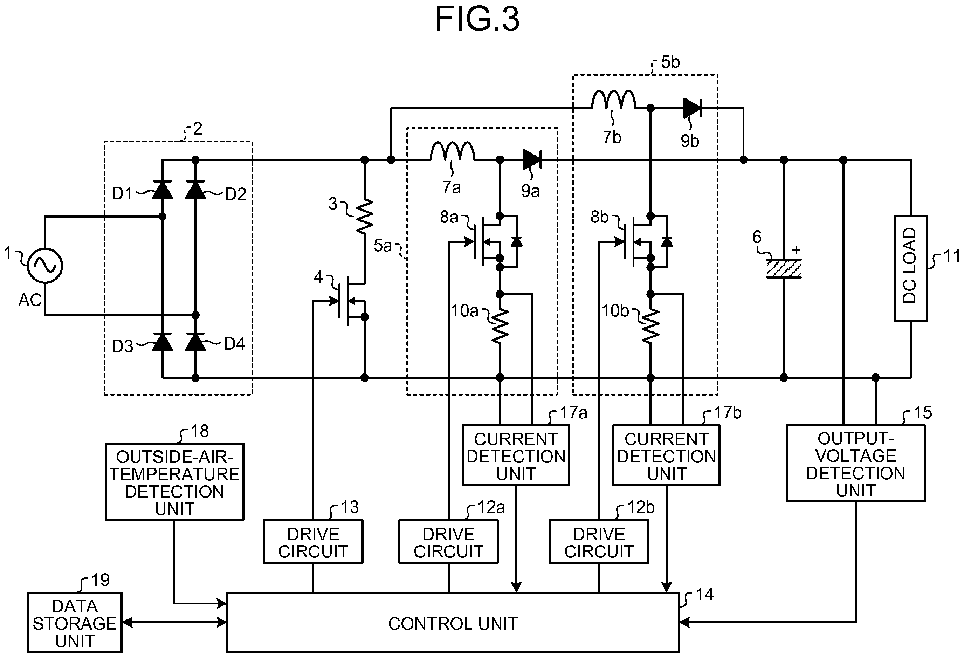

The power supply device according to the first example uses a heatsink temperature detected by the heatsink-temperature detection unit 16 at the time of control executed by the control unit 14. However, a power supply device according to a first embodiment of the present invention executes control by using an outside air temperature instead of the temperature of the heatsink, assuming a case where the power supply device is installed outdoors. Configurations and operations of the power supply device according to the first embodiment will be explained with reference to the accompanying drawings. FIG. 3 is a configuration diagram of the power supply device (a converter device) that performs a converter operation according to the first embodiment. In FIG. 3, an outside-air-temperature detection unit 18 is constituted by a thermistor or the like to detect an ambient outside air temperature in a place where the power supply device is installed. When the power supply device is incorporated in an electric device installed outdoors, the electric device may include an outside-air-temperature detection unit for other purposes, and in this case, the outside-air-temperature detection unit may be used as a substitute of the outside-air-temperature detection unit 18.

A data storage unit 19 stores therein an energizing time threshold of the heating resistor 3 for each outside air temperature as data in advance. Data contents will be described later.

The control unit 14 generates a drive signal for ON/OFF control of the semiconductor switching device 4 and the semiconductor switching devices 8a and 8b based on: a voltage between both terminals of the smoothing unit 6 detected by the output-voltage detection unit 15; a value of a current flowing in the shunt resistors 10a and 10b detected by the current detection units 17a and 17b; and an outside air temperature detected by the outside-air-temperature detection unit 18, and the control unit 14 outputs the drive signal to the drive circuits 12a and 12b, and the drive circuit 13. Other constituent parts are identical to the configuration according to the first example shown in FIG. 1, and are therefore designated by like reference signs and thus explanations thereof will be omitted.

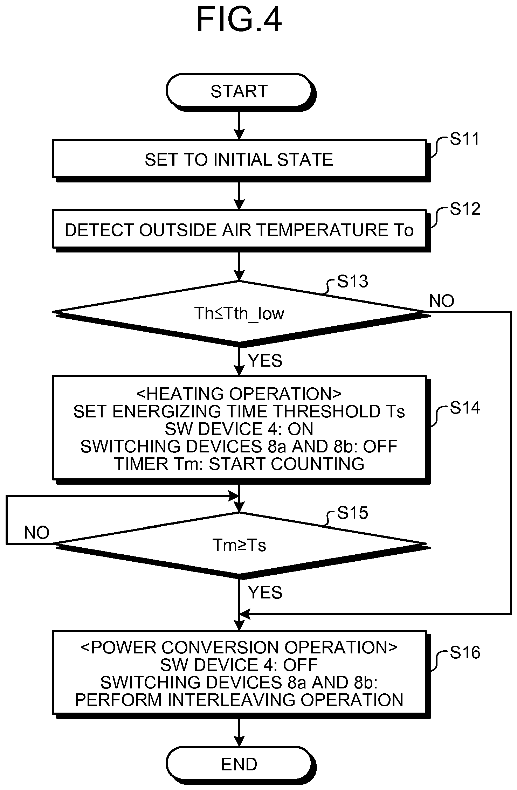

The control unit 14 controls the switching operation of the semiconductor switching device 4 and the semiconductor switching devices 8a and 8b according to an operation flow shown in FIG. 4. The operations will be explained below according to an operation flowchart.

The control unit 14 first outputs a gate control signal to set the semiconductor switching device 4 and the semiconductor switching devices 8a and 8b to the OFF state, respectively, to the drive circuit 13 and the drive circuits 12a and 12b, thereby setting the power supply device to an initial state before starting a power conversion operation (a converter operation) (Step S11).

At the time of shifting of the power supply device to the power conversion operation, the control unit 14 detects an outside air temperature To by the outside-air-temperature detection unit 18 (Step S12), and compares the low temperature threshold Tth_low which is a threshold temperature set to the power supply device in advance, with the detected outside air temperature To (Step S13).

The value of the low temperature threshold Tth_low means a lower limit temperature for permitting conduction of the wide bandgap semiconductor device, which is used in the semiconductor switching devices 8a and 8b, similarly to the first example. In the first embodiment, it is assumed that the power supply device is installed outdoors. For example, a case where the power supply device is mounted on an outdoor unit of an air conditioner corresponds to this case. In this case, the temperature of an electronic component in the outdoor unit before startup of the outdoor unit is considered to be equal to or higher than the outside air temperature. Therefore, in a state where the outside air temperature To is higher than the low temperature threshold Tth_low, it can be regarded that the temperature of the semiconductor switching devices 8a and 8b is also higher than the low temperature threshold Tth_low.

When the outside air temperature To is higher than the low temperature threshold Tth_low (NO at Step S13), the control unit 14 maintains the OFF state of the semiconductor switching device 4, and starts an interleaving operation of the semiconductor switching devices 8a and 8b. Accordingly, the power conversion operation (the power-factor improving converter operation) of the power supply device is realized (Step S16).

When the outside air temperature To is equal to or lower than the low temperature threshold Tth_low (YES at Step S13), the control unit 14 performs a heating operation (Step S14). Specifically, the control unit 14 performs the heating operation according to a procedure described below. First, the control unit 14 reads energizing time data (a threshold time) of the heating resistor 3, which is a predetermined time corresponding to the outside air temperature held in advance in the data storage unit 19 to set an energizing time threshold Ts corresponding to the outside air temperature To. The energizing time threshold Ts means an energizing time of the heating resistor 3 required for heating the semiconductor switching devices 8a and 8b up to a predetermined temperature at which there is no risk of thermal destruction of the semiconductor switching devices 8a and 8b, when the outside air temperature To is at a predetermined temperature or in a predetermined temperature range. The energizing time threshold Ts may be a value obtained in advance by research such as experiments, or a value calculated in advance by computer simulation may be used.

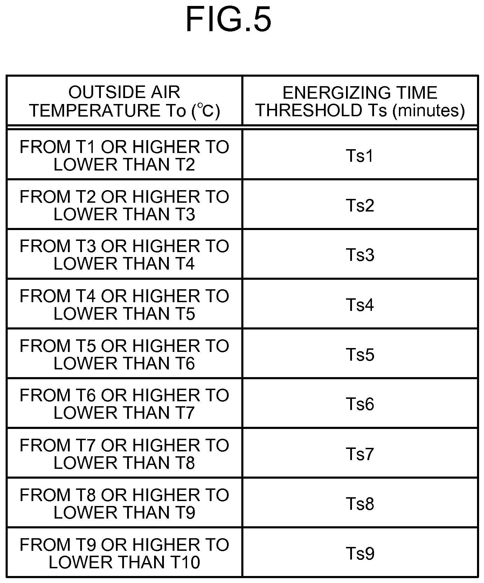

FIG. 5 shows data contents of the energizing time data held in the data storage unit 19. The energizing time data is configured to correspond to the energizing time threshold Ts corresponding to each range of the outside air temperature To. For example, when the outside air temperature To is T5≤To<T6, the energizing time threshold Ts is Ts5.

After the energizing time threshold Ts is set, the semiconductor switching device 4 is set to an ON state. Accordingly, the heating resistor 3 is energized, and the semiconductor switching devices 8a and 8b are heated (the heating operation) by heat generated due to conduction loss of the heating resistor 3, to increase the temperature of the semiconductor switching devices 8a and 8b. The semiconductor switching devices 8a and 8b maintain the OFF state and do not perform the switching operation. The energizing time is measured by starting a counting operation from Tm=0 by an energizing-time measuring timer Tm provided in the control unit 14.

When energizing of the heating resistor 3 is performed, the temperature of the semiconductor switching devices 8a and 8b increases. Meanwhile, because the outside air temperature has no relation to a temperature change of the semiconductor switching device, a finish timing of energizing of the heating resistor 3 should not be determined based on the outside air temperature. Therefore, the control unit 14 compares the value of the energizing-time measuring timer Tm with the energizing time threshold Ts to ascertain an energizing elapsed time with respect to the heating resistor 3, and to determine the finish timing of energizing to the heating resistor 3 (Step S15).

When the value of the energizing-time measuring timer Tm is smaller than the energizing time threshold Ts (NO at Step S15), the control unit 14 continues the comparison between the value of the energizing-time measuring timer Tm and the energizing time threshold Ts.

On the other hand, when the value of the energizing-time measuring timer Tm is equal to or larger than the energizing time threshold Ts (YES at Step S15), the control unit 14 sets the semiconductor switching device 4 to an OFF state, thereby stopping energizing of the heating resistor 3. Accordingly, the heating operation to the semiconductor switching devices 8a and 8b is stopped. The control unit 14 also starts the interleaving operation of switching of the semiconductor switching devices 8a and 8b. Accordingly, the power conversion operation (the power-factor improving converter operation) of the power supply device is realized (Step S16).

As described above, the power supply device according to the first embodiment performs the heating operation by energizing of the heating resistor based on the outside air temperature detected by the outside-air-temperature detection unit and the energizing time data of the heating resistor for each outside air temperature held in advance in the data storage unit. Accordingly, startup control of the power supply device in a low temperature environment can be realized at a low cost, by using the existing outside-air-temperature detection unit.

The control unit 14 in the above descriptions executes the control by using the energizing time data of the heating resistor held in the data storage unit. However, the configuration can be modified such that a calculation formula for calculating the energizing time data of the heating resistor based on an outside air temperature may be incorporated in the control unit 14 in advance, so that the energizing time threshold Ts corresponding to the outside air temperature can be calculated according to the calculation formula.

### Second embodiment.

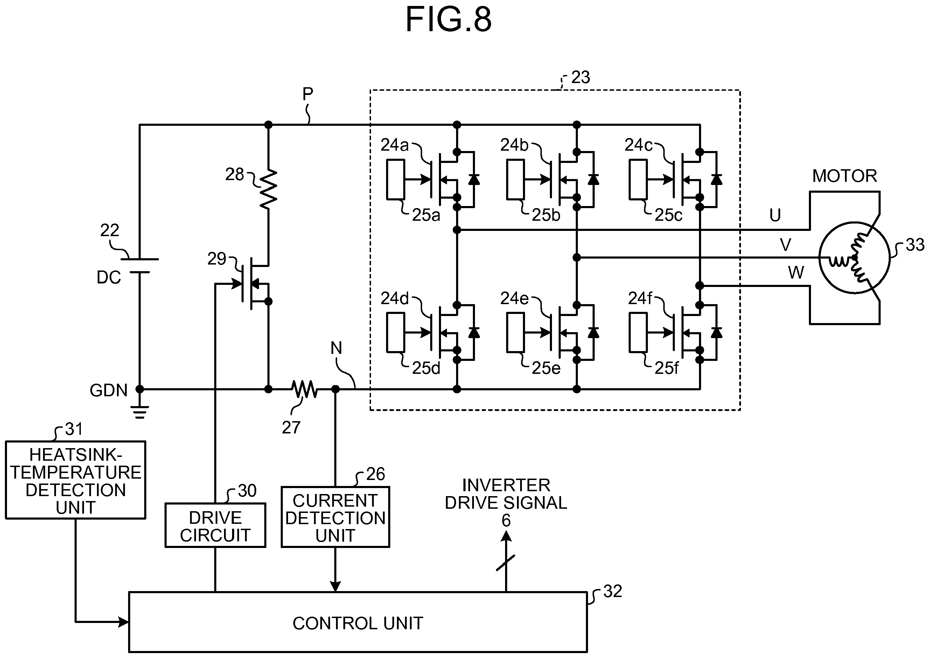

The power supply device according to the first and first embodiments is a device (a converter device) that performs a converter operation. However, in a second embodiment of the present invention, a case where a power supply device is a device (an inverter device) that performs an inverter operation for converting DC power to AC power will be explained. FIG. 8 is a configuration diagram of the power supply device that performs an inverter operation (the inverter device). In the power supply device shown in FIG. 8, a DC power supply 22 outputs a DC voltage between a positive side P and a negative side N of a DC bus by using GND (ground) as a potential reference. An inverter main circuit 23 includes upper-arm semiconductor switching devices 24a to 24c, lower-arm semiconductor switching devices 24d to 24f, and drive circuits 25a to 25f that respectively drive the semiconductor switching devices 24a to 24f. The semiconductor switching devices 24a to 24f are semiconductor switching devices formed of a wide bandgap semiconductor such as silicon carbide (SiC) (for example, a SiC n-type MOSFET). A current detection unit 26 detects a DC current flowing in a shunt resistor 27 provided on the negative side N of the DC bus between the DC power supply 22 and the inverter main circuit 23. Furthermore, a heating resistor 28 and a semiconductor switching device 29 (for example, a silicon n-type MOSFET) formed of a silicon semiconductor are serially connected between the positive side P and the negative side N of the DC bus. The semiconductor switching device 29 is driven ON and OFF by a drive circuit 30. The DC power supply 22 and the inverter main circuit 23 constitute a power conversion unit that performs an inverter operation.

A heatsink-temperature detection unit 31 is constituted by a thermistor or the like, and installed around a heatsink (not shown) provided for heat dissipation of respective devices of the semiconductor switching devices 24a to 24f or installed in direct contact with the heatsink to detect the temperature of the heatsink.

A control unit 32 generates a drive signal for respectively executing ON/OFF control of the semiconductor switching devices 24a to 24f and the semiconductor switching device 29 based on: a DC current detected by the current detection unit 26; a heatsink temperature detected by the heatsink-temperature detection unit 31; and an operation command value (not shown), and the control unit 32 outputs the drive signal to the drive circuits 25a to 25f and to the drive circuit 30.

As a load device of the inverter main circuit 23, a three-phase motor 33 is connected by three-phase connection of U, V, and W. As the load device, a load device that can be driven by the inverter main circuit 23 may be used, and is not limited to the three-phase motor 33.

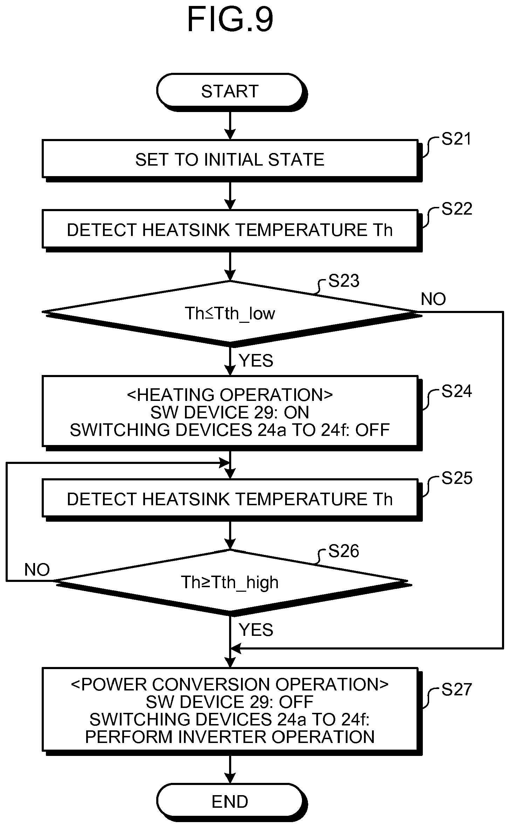

Operations of the power supply device configured in this manner will be explained next. The control unit 32 controls the switching operation of the semiconductor switching device 29 and the semiconductor switching devices 24a to 24f according to an operation flow shown in FIG. 9. The operations will be explained according to an operation flowchart.

The control unit 32 first outputs a drive signal for setting the semiconductor switching device 29 and the semiconductor switching devices 24a to 24f to an OFF state respectively to the drive circuit 30 and the drive circuits 25a to 25f, thereby setting the power supply device to an initial state before starting a power conversion operation (the inverter operation) (Step S21).

At the time of shifting of the power supply device to the power conversion operation, the control unit 32 detects the heatsink temperature Th by the heatsink-temperature detection unit 31 (Step S22), and compares the low temperature threshold Tth_low which is the threshold temperature set to the power supply device in advance with the detected heatsink temperature Th (Step S23). As explained in the first embodiment, the low temperature threshold Tth_low may be set as a lower limit temperature for permitting conduction of the wide bandgap semiconductor device.

When the heatsink temperature Th is higher than the low temperature threshold Tth_low (NO at Step S23), the control unit 32 maintains the OFF state of the semiconductor switching device 29, and starts the inverter operation of the semiconductor switching devices 24a to 24f. Accordingly, the DC power from the DC power supply 22 is converted to a three-phase AC power, thereby driving the motor 33. In this manner, the power conversion operation (the inverter operation) of the power supply device is realized (Step S27).

The control unit 32 uses a known inverter control technique such as vector control to perform the power conversion operation (the inverter operation), based on the DC current detected by the current detection unit 26, the heatsink temperature detected by the heatsink-temperature detection unit 31, and an operation command value (not shown).

When the heatsink temperature Th is equal to or lower than the low temperature threshold Tth_low (YES at Step S23), the control unit 32 sets the semiconductor switching device 29 to an ON state. Accordingly, the heating resistor 28 is energized and the semiconductor switching devices 24a to 24f are heated (a heating operation) by heat generated due to conduction loss of the heating resistor 28, to increase the temperature of the semiconductor switching device constituting the semiconductor switching devices 24a to 24f. The semiconductor switching devices 24a to 24f maintain the OFF state and do not perform the switching operation (Step S24).

To heat the semiconductor switching devices 24a to 24f more efficiently, it is desirable to arrange the heating resistor 28 in the vicinity of the semiconductor switching devices 24a to 24f, or arrange the heating resistor 28 in contact with the semiconductor switching devices 24a to 24f.

Thereafter, the control unit 32 detects the heatsink temperature Th by the heatsink-temperature detection unit 31 (Step S25), and compares the detected heatsink temperature Th with the high temperature threshold Tth_high which is the threshold temperature set to the power supply device in advance (Step S26). The value of the high temperature threshold Tth_high may be set based on the concept explained in the first example.

When the heatsink temperature Th is lower than the high temperature threshold Tth_high (NO at Step S26), the flow returns to Step S25 to continue detecting the heatsink temperature, and the control unit 32 continues comparing between the detected heatsink temperature Th and the high temperature threshold Tth_high. When the semiconductor switching devices 24a to 24f are heated and the temperature of the semiconductor switching devices 24a to 24f increases, the temperature of the heatsink itself attached to the semiconductor switching devices 24a to 24f also increases. Therefore, by confirming the heatsink temperature Th continuously, a temperature rise of the semiconductor switching devices 24a to 24f can be estimated.

When the heatsink temperature Th is equal to or higher than the high temperature threshold Tth_high (YES at Step S26), the control unit 32 sets the semiconductor switching device 29 to an OFF state, to stop energizing of the heating resistor 28. Accordingly, the heating operation with respect to the semiconductor switching devices 24a to 24f is stopped. Furthermore, the inverter operation of the semiconductor switching devices 24a to 24f is started. Accordingly, the power conversion operation (the inverter operation) of the power supply device is realized (Step S27) .

When the semiconductor switching devices 24a to 24f can start the switching operation normally, the temperature of the semiconductor switching devices 24a to 24f gradually increases by self-heating caused by the switching operation. Therefore, the temperature of the semiconductor switching devices 24a to 24f does not drop to a low temperature region in which there is a risk of thermal destruction. Thereafter, the semiconductor switching devices 24a to 24f can be operated continuously in an appropriate temperature range by a cooling function of the heatsink and a cooling fan (not shown).

In the above explanations, the semiconductor switching devices 24a to 24f are formed of a wide bandgap semiconductor. However, the semiconductor switching devices 24a to 24f are not limited thereto, but some of the semiconductor switching devices 24a to 24f may be formed of a wide bandgap semiconductor, and the remaining ones may be formed of an Si semiconductor.

A resistor (having a three-shunt configuration) may be provided between the lower-arm semiconductor switching devices 24d to 24f and the negative side N of the DC bus instead of the current detection unit 26, and a current detection unit that detects a current flowing in the resistor may be provided.

As described above, similarly to the power supply device described in the first example, the power supply device (the inverter device) according to the second embodiment heats the semiconductor switching device by heat generation generated by energizing the heating resistor, so that the temperature of the semiconductor switching device is changed to a temperature region in which a stable operation is possible, when the device temperature of the semiconductor switching device formed of the wide bandgap semiconductor such as silicon carbide (SiC) used by the power supply device is in a low temperature region in which a stable operation cannot be ensured. Accordingly, even at the time of startup of the inverter device in a low temperature environment, thermal destruction of the semiconductor switching device can be prevented and the temperature region in which energizing of the inverter device can be started can be extended.

Also in the power supply device (the inverter device), as explained in the first embodiment (the converter device), of course, the outside-air-temperature detection unit and the data storage unit can be provided instead of the heatsink-temperature detection unit 31 to execute startup control based on the outside air temperature.

According to the first to second embodiments, the power supply device using a semiconductor switching device formed of a wide bandgap semiconductor such as silicon carbide (SiC) has been explained. However, the semiconductor switching device is not limited to the wide bandgap semiconductor, and the same configuration can be applied to a power supply device using a semiconductor switching device in which the electric resistance of the device increases in a low temperature environment.

The power supply device according to the present invention can extend the temperature region in which the semiconductor switching devices constituting the power conversion unit can be driven, and thus the power supply device that can withstand use in a low temperature environment can be provided.

## Claims

1. A power supply device comprising:
a power conversion unit that includes two or more first semiconductor switching devices (8a, 8b) and performs a converter operation configured to convert an AC power to a DC power or an inverter operation configured to convert a DC power to an AC power;
a heating resistor (3) configured to heat the first semiconductor switching devices (8a, 8b);
a second semiconductor switching device (4) configured to control conduction of the heating resistor (3);
a temperature detection unit (18) configured to detect an outside air temperature of a place where the power supply device is installed; and
a control unit (14) configured to generate a drive signal for controlling ON and OFF of the first semiconductor switching devices (8a, 8b) and
the second semiconductor switching device (4) by using a temperature detected by the temperature detection unit (18), wherein the control unit (14) is configured to generate, when the outside air temperature is equal to or lower than a first threshold temperature set in advance, a drive signal for setting the second semiconductor switching device (4) to an ON state, and thereafter, after a preset predetermined time has passed, the control unit (14) is configured to generate a drive signal for setting the second semiconductor switching device (4) to an OFF state and is configured to start an interleaving operation of the first semiconductor switching devices (8a, 8b).

2. The power supply device according to claim 1, further comprising a data storage unit (19) configured to hold a threshold time corresponding to the temperature detected by the temperature detection unit (18) as data, wherein
the control unit (14) is configured to use a threshold time held in the data storage unit (19) as a preset predetermined time.

3. The power supply device according to any one of claims 1 to 2, wherein
the power conversion unit includes
a rectifying unit that rectifies an AC voltage of an AC power supply to a DC voltage,
a smoothing unit configured to smooth a DC voltage, and
one or more booster units connected between the rectifying unit and the smoothing unit and respectively including a boosting reactor, the first semiconductor switching devices (8a, 8b), and a backflow prevention diode, and
the heating resistor (3) and the second semiconductor switching device (4) are serially connected between output terminals of the rectifying unit.

4. The power supply device according to any one of claims 1 to 2, wherein
the power conversion unit includes
a DC power supply configured to output a DC voltage to between DC buses, and
an inverter main circuit in which an upper arm and a lower arm, respectively having the first semiconductor switching devices (8a, 8b) and the drive circuits that respectively drive the first semiconductor switching device (8a, 8b), are serially connected between the DC buses, and
the heating resistor (3) and the second semiconductor switching device (4) are serially connected between output terminals of the DC power supply.

5. The power supply device according to any one of claims 1 to 4, wherein some of or all of the first semiconductor switching devices (8a, 8b) are formed of a wide bandgap semiconductor device.

6. The power supply device according to claim 5, wherein the wide bandgap semiconductor is made of silicon carbide (SiC), a gallium nitride (GaN)-based material, or diamond.

7. A control method of a power supply device including a power conversion unit that has two or more first semiconductor switching devices (8a, 8b) and performs a converter operation for converting an AC power to a DC power or an inverter operation for converting a DC power to an AC power, the control method comprising:
setting a second semiconductor switching device (4) configured to control conduction of a heating resistor (3) to an ON state and heating the first semiconductor switching devices (8a, 8b), when an outside air temperature of a place where the power supply device is installed is equal to or lower than a first threshold temperature set in advance; and
thereafter, after a preset predetermined time has passed, setting the second semiconductor switching device (4) to an OFF state and stopping heating of the first semiconductor switching devices (8a, 8b) and starting an interleaving operation of the first semiconductor switching devices (8a, 8b) .

## Patentansprüche

1. Stromversorgungseinrichtung, umfassend:
eine Leistungsumwandlungseinheit, die zwei oder mehr erste Halbleiterschalteinrichtungen (8a, 8b) enthält, und einen Umwandlungsvorgang, der eingerichtet ist, einen Wechselstrom in einen Gleichstrom umzuwandeln oder einen Wechselrichtervorgang, der eingerichtet ist, einen Gleichstrom in einen Wechselstrom umzuwandeln, durchführt;
einen Heizwiderstand (3), der eingerichtet ist, die ersten Halbleiterschalteinrichtungen (8a, 8b) zu erhitzen;
eine zweite Halbleiterschalteinrichtung (4), die eingerichtet ist, das Leitvermögen des Heizwiderstands (3) zu steuern;
eine Temperaturerfassungseinheit (18), die eingerichtet ist, eine Außenlufttemperatur eines Ortes, an dem die Stromversorgungseinrichtung installiert ist, zu erfassen; und
eine Steuerungseinheit (14), die eingerichtet ist, ein Antriebssignal zum Steuern von EIN und AUS der ersten Halbleiterschalteinrichtungen (8a, 8b) und der zweiten Halbleiterschalteinrichtung (4) unter Verwendung einer durch die Temperaturerfassungseinheit (18) erfassten Temperatur zu erzeugen, wobei
die Steuerungseinheit (14) eingerichtet ist, wenn die Außenlufttemperatur gleich wie oder niedriger als eine erste, im Voraus eingestellte Schwellentemperatur ist, ein Antriebssignal zu erzeugen, um die zweite Halbleiterschalteinrichtung (4) in einen EIN-Zustand zu versetzen, und danach, nachdem eine voreingestellte vorbestimmte Zeit verstrichen ist, die Steuerungseinheit (14) eingerichtet ist, ein Antriebssignal zu erzeugen, um die zweite Halbleiterschalteinrichtung (4) in einen AUS-Zustand zu versetzen, und eingerichtet ist, einen Verschachtelungsvorgang der ersten Halbleiterschalteinrichtungen (8a, 8b) zu starten.

2. Stromversorgungseinrichtung nach Anspruch 1, ferner umfassend eine Datenspeichereinheit (19), die eingerichtet ist, eine Schwellenwertzeit, die der durch die Temperaturerfassungseinheit (18) erfassten Temperatur entspricht, als Daten zu enthalten, wobei
die Steuerungseinheit (14) eingerichtet ist, eine in der Datenspeichereinheit (19) enthaltene Schwellenwertzeit als eine voreingestellte vorbestimmte Zeit zu verwenden.

3. Stromversorgungseinrichtung nach einem der Ansprüche 1 bis 2, wobei
die Leistungsumwandlungseinheit umfasst
eine Gleichrichtereinheit, die eine Wechselspannung einer Wechselstromversorgung in eine Gleichspannung gleichrichtet,
eine Glättungseinheit, die eingerichtet ist, eine Gleichspannung zu glätten, und
eine oder mehrere Verstärkereinheiten, die zwischen der Gleichrichtereinheit und der Glättungseinheit verbunden sind und jeweils eine Verstärkungsdrossel, die ersten Halbleiterschalteinrichtungen (8a, 8b) und eine Rückflussverhinderungsdiode enthalten, und
der Heizwiderstand (3) und die zweite Halbleiterschalteinrichtung (4) in Reihe zwischen Ausgangsanschlüssen der Gleichrichtereinheit verbunden sind.

4. Stromversorgungseinrichtung nach einem der Ansprüche 1 bis 2, wobei
die Leistungsumwandlungseinheit umfasst
eine Gleichstromversorgung, die eingerichtet ist, eine Gleichspannung zwischen Gleichstrombusse auszugeben, und
einen Wechselrichter-Hauptschaltkreis, in dem ein oberer Arm und ein unterer Arm, die jeweils die ersten Halbleiterschalteinrichtungen (8a, 8b) und die Antriebsschaltkreise, die jeweils die erste Halbleiterschalteinrichtung (8a, 8b) antreiben, zwischen den Gleichstrombussen in Reihe verbunden sind, und
der Heizwiderstand (3) und die zweite Halbleiterschalteinrichtung (4) zwischen Ausgangsanschlüssen der Gleichstromversorgung in Reihe verbunden sind.

5. Stromversorgungseinrichtung nach einem der Ansprüche 1 bis 4, wobei einige oder alle der ersten Halbleiterschalteinrichtungen (8a, 8b) aus einer Halbleitereinrichtung mit breiter Bandlücke gebildet sind.

6. Stromversorgungseinrichtung nach Anspruch 5, wobei der Halbleiter mit breiter Bandlücke aus Siliziumkarbid (SiC), einem Material auf Galliumnitridbasis (GaN) oder Diamant gefertigt ist.

7. Steuerungsverfahren einer Stromversorgungseinrichtung, umfassend eine Leistungsumwandlungseinheit, die zwei oder mehr erste Halbleiterschalteinrichtungen (8a, 8b) aufweist und einen Umwandlungsvorgang zum Umwandeln eines Wechselstroms in einen Gleichstrom, oder einen Wechselrichterbetrieb zum Umwandeln eines Gleichstroms in einen Wechselstrom durchführt, wobei das Verfahren umfasst:
Einstellen einer zweiten Halbleiterschalteinrichtung (4), die eingerichtet ist, das Leitvermögen eines Heizwiderstands (3) zu steuern, auf einen EIN-Zustand, und Erhitzen der ersten Halbleiterschalteinrichtungen (8a, 8b), wenn eine Außenlufttemperatur eines Ortes, an dem die Stromversorgungseinrichtung installiert ist, gleich wie oder niedriger als eine im Vorhinein eingestellte erste Schwellenwerttemperatur ist; und
danach, nachdem eine voreingestellte vorbestimmte Zeit verstrichen ist, Einstellen der zweiten Halbleiterschalteinrichtung (4) auf einen AUS-Zustand und Stoppen des Erhitzens der ersten Halbleiterschalteinrichtungen (8a, 8b) und Starten eines Verschachtelungsvorgangs der ersten Halbleiterschalteinrichtungen (8a, 8b).

## Revendications

1. Dispositif d'alimentation comprenant :
une unité de conversion de puissance qui comprend deux premiers dispositifs de commutation à semi-conducteur (8a, 8b) ou plus, et qui exécute une opération de convertisseur, configurée pour convertir une alimentation AC en une alimentation DC, ou une opération de convertisseur, configurée pour convertir une alimentation DC en une alimentation AC ;
un résisteur de chauffage (3) configuré pour chauffer les premiers dispositifs de commutation à semi-conducteur (8a, 8b) ;
un second dispositif de commutation à semi-conducteur (4) configuré pour commander la conduction du résisteur de chauffage (3) ;
une unité de détection de la température (18) configurée pour détecter la température de l'air extérieur de l'endroit où est installé le dispositif d'alimentation ; et
une unité de commande (14) configurée pour générer un signal de commande destiné à commander l'état passant et l'état bloqué des premiers dispositifs de commutation à semi-conducteur (8a, 8b), et le second dispositif de commutation à semi-conducteur (4) à l'aide de la température détectée par l'unité de détection de la température (18),
où l'unité de commande (14) est configurée pour générer, lorsque la température de l'air extérieur est égale ou inférieure à une première température de seuil réglée à l'avance, un signal de commande visant à placer le second dispositif de commutation à semi-conducteur (4) dans l'état passant, et ensuite, une fois qu'un temps prédéterminé préréglé s'est écoulé, l'unité de commande (14) est configurée pour générer un signal de commande visant à placer le second dispositif de commutation à semi-conducteur (4) dans l'état bloqué, et est configurée pour démarrer une opération d'intercalage des premiers dispositifs de commutation à semi-conducteur (8a, 8b).

2. Dispositif d'alimentation selon la revendication 1, comprenant en outre une unité de stockage de données (19) configurée pour contenir un temps de seuil correspondant à la température détectée par l'unité de détection de la température (18) en tant que données,
où l'unité de commande (14) est configurée pour utiliser un temps de seuil contenu dans l'unité de stockage de données (19) en tant que temps prédéterminé préréglé.

3. Dispositif d'alimentation selon la revendication 1 ou 2,
où l'unité de conversion de puissance comprend
une unité de redressement qui redresse la tension AC d'une alimentation AC en une tension DC,
une unité de lissage configurée pour lisser une tension DC, et
une ou plusieurs unités amplificatrices connectées entre l'unité de redressement et l'unité de lissage, et comprenant respectivement un élément réactif d'amplification, les premiers dispositifs de commutation à semi-conducteur (8a, 8b), et une diode de non-retour, et
le résisteur de chauffage (3) et le second dispositif de commutation à semi-conducteur (4) sont connectés en série entre les bornes de sortie de l'unité de redressement.

4. Dispositif d'alimentation selon la revendication 1 ou 2,
où l'unité de conversion de puissance comprend
une alimentation DC configurée pour délivrer en sortie une tension DC à des barres omnibus DC, et
un circuit principal d'onduleur dans lequel la branche supérieure et la branche inférieure, présentant respectivement les premiers dispositifs de commutation à semi-conducteur (8a, 8b) et les circuits de commande qui commandent respectivement les premiers dispositif de commutation à semi-conducteur (8a, 8b), sont connectées en série entre les barres omnibus DC, et
le résisteur de chauffage (3) et le second dispositif de commutation à semi-conducteur (4) sont connectés en série entre les bornes de sortie de l'alimentation DC.

5. Dispositif d'alimentation selon l'une quelconque des revendications 1 à 4,
où certains des premiers dispositifs de commutation à semi-conducteur (8a, 8b), voire tous, sont constitués d'un dispositif de semi-conducteur à large bande interdite.

6. Dispositif d'alimentation selon la revendication 5,
où le semi-conducteur à large bande interdite est constitué d'un matériau à base de carbure de silicium (SiC), de nitrure de gallium (GaN), ou de diamant.

7. Procédé de commande d'un dispositif d'alimentation comprenant une unité de conversion de puissance qui présentent deux premiers dispositifs de commutation à semi-conducteur (8a, 8b) ou plus, et qui exécute une opération de convertisseur afin de convertir une alimentation AC en une alimentation DC, ou une opération de convertisseur afin de convertir une alimentation DC en une alimentation AC, le procédé de commande comprenant les étapes suivantes :
régler un second dispositif de commutation à semi-conducteur (4) configuré pour commander la conduction d'un résisteur de chauffage (3) dans un état passant, et chauffer les premiers dispositifs de commutation à semi-conducteur (8a, 8b), lorsque la température de l'air extérieur de l'endroit où est installé le dispositif d'alimentation, est égale ou inférieure à une première température de seuil réglée à l'avance ; et
ensuite, une fois qu'un temps prédéterminé préréglé s'est écoulé, régler le second dispositif de commutation à semi-conducteur (4) dans l'état bloqué, et arrêter le chauffage des premiers dispositifs de commutation à semi-conducteur (8a, 8b), et démarrer une opération d'intercalage des premiers dispositifs de commutation à semi-conducteur (8a, 8b).
